# EUROPÄISCHE PATENTANMELDUNG

(11) **EP 1 293 945 A1**
(43) Veröffentlichungstag der Anmeldung: **19.03.2003**
(21) Anmeldenummer: 01122163.7
(22) Anmeldetag: 15.09.2001
(51) Int. Cl.: G08B 17/00

(54) **Verfahren und Planungswerkzeug zur Durchführung von Projektierungsabläufen für Gefahrenmeldeanlagen sowie Rechnersystem zur Durchführung des Verfahrens**

(71) Anmelder: Siemens Building Technologies AG, 8034 Zürich (CH)
(72) Erfinder: Späni, Markus, CH-8608 Bubikon (CH); Covelli, Bruno Dr., CH-5034 Suhr (CH); Nebiker, Peter Dr., CH-8053 Zürich (CH)
(74) Vertreter: Dittrich, Horst, Dr.

(57) **Zusammenfassung**

Das Verfahren verwendet ein auf einem Rechner (1) implementierbares Planungswerkzeug für die Berechnung von Brandentwicklungen und des Ansprechverhaltens von Brandmeldeanlagen anhand eines Brandmodells und von Parametern. Das Planungswerkzeug umfasst ein erstes Modul für die Berechnung der Rauch- und Temperaturentwicklung eines definierten Feuers in einem definierten Raum und ein zweites Modul für die Auswahl und richtige Platzierung von Feuermeldern, wobei das zweite Modul die Eigenschaften der Melder mit der Entwicklung des definierten Feuers in dem definierten Raum verbindet. Die beiden Module bilden Teil eines auf einem Datenträger (4) gespeicherten Programms.

Das Rechnersystem zur Durchführung des Verfahrens umfasst einen Laptop oder einenanderen transportablen Rechner (1) mit einer Eingabetastatur (2) für die Eingabe der genannten Parameter, einem Bildschirm (3) und einem Disketten- und/oder CD-ROM-Laufwerk zur Aufnahme des genannten Datenträgers (4).

## Beschreibung

Die vorliegende Erfindung betrifft ein Verfahren zur Durchführung von Projektierungsabläufen für Gefahrenmeldeanlagen mit Hilfe eines Rechners, ein Planungswerkzeug zu derenUnterstützung und ein Rechnersystem zur Durchführung des Verfahrens.

Gefahrenmeldeanlagen, insbesondere Brandmeldeanlagen, werden vermehrt nur noch anhand der lokalen Vorschriften (Anzahl der überwachten Quadratmeter pro Melder) geplant undkonfiguriert. Während diese Art der Planung und Konfiguration für übliche Räume, wiebeispielsweise Büros oder Hotelzimmer, durchaus ausreichend sein mag, ist es für vom üblichenDurchschnitt abweichende Räume, wie beispielsweise Ausstellungs- oder Produktionsräume, Schulen, Krankenhäuser und dergleichen, nicht ausreichend. Denn was der Kunde wünscht, ist eine an das real gegebene Risiko angepasste Brandmeldeanlage, oder allgemein, Gefahrenmeldeanlage. Um aber einen von der Norm abweichenden Raum angepasst an die Raumgeometrie, das vorhandene Risiko und die vorhandene Brandlast zu schützen, ist ein umfangreichesApplikationswissen erforderlich.

Mit dem erfindungsgemässen Verfahren soll nun den Personen im Feld ein Hilfsmittel zurVerfügung gestellt werden, welches folgende Arbeiten unterstützt:
- Planung einer Brandmeldeanlage für ein schwieriges Umfeld (Auswahl, Konfiguration und Positionierung der Melder),
- Abschätzung des Ansprechverhaltens einer Brandmeldeanlage (Feuergrösse, Ansprechzeit).

Die Aufgabe wird erfindungsgemäss gelöst durch auf dem Rechner implementierbares Planungswerkzeug für die Berechnung von Brandentwicklungen und des Ansprechverhaltens von Brandmeldeanlagen anhand eines Brandmodells und von Parametern.

Eine erste bevorzugte Ausführungsform des erfindungsgemässen Verfahrens ist dadurch gekennzeichnet, dass das Planungswerkzeug ein erstes Modul für die Berechnung der Rauchund Temperaturentwicklung eines definierten Feuers in einem definierten Raum und ein zweites Modul für die Auswahl und richtige Platzierung von Feuermeldern umfasst, wobei das zweite Modul die Eigenschaften der Melder mit der Entwicklung des definierten Feuers in demdefinierten Raum verbindet.

Das erste Modul liefert also Angaben über die Entwicklung eines Feuers in dem jeweiligen Raum, über den Einfluss der Brandlast oder gegebenenfalls der Ventilation auf das Feuer, über Rauchkonzentration und Flammenhöhe, und so weiter. Das zweite Modul gibt Antwortenbezüglich des Ansprechverhaltens der Brandmeldeanlage, und zwar sowohl aus Sicht Feuer wie auch aus Sicht Melder. Die Parameter werden vorzugsweise in den Rechner eingegeben.

Eine zweite bevorzugte Ausführungsform des erfindungsgemässen Verfahrens ist dadurch gekennzeichnet, dass für die Berechnungen des ersten Moduls die Parameter Raum und Feuer und für die Berechnungen des zweiten Moduls die Parameter Raum, Feuer, Melder undAnsprechzeit eingegeben werden.

Vorzugsweise enthält der Parameter Raum Angaben über einen oder mehrere der Werte Raumgeometrie, Ventilation, Umgebungstemperatur und Umgebungsdruck und der Parameter Feuer Angaben über die Eigenschaften und/oder die Position des Feuers. Die Angaben über die Eigenschaften des Feuers enthalten Werte betreffend die Brandlast und/oder dieBrandoberfläche und/oder einen eventuellen Sauerstoffüberschuss und der Parameter Melder enthält Angaben über Eigenschaften und/oder Position der in Frage kommenden Brandmelder.

Eine weitere bevorzugte Ausführungsform des erfindungsgemässen Verfahrens ist dadurch gekennzeichnet, dass vom ersten Modul einer oder mehrere der Werte Thermodynamik (Energie- und Massenbilanz in der Reaktionszone und im Plume), Gasentwicklung, Rauchentwicklung, Rauch- und Brandgasschicht und Abbrandgewicht berechnet und ausgegeben werden.

Gemäss einer weiteren bevorzugten Ausführungsform des erfindungsgemässen Verfahrens werden vom zweiten Modul je nach Eingabe-Parametern Angaben betreffend Alarmauslösung in Abhängigkeit von Meldertyp und Melderposition oder betreffend Meldertyp undMelderposition in Abhängigkeit vom Feuer ausgegeben.

Die Erfindung betrifft weiter ein Planungswerkzeug zur Unterstützung von Projektierungsabläufen für Gefahrenmeldeanlagen.

Das erfindungsgemässe Planungswerkzeug ist gekennzeichnet durch ein erstes Modul für die Berechnung der Rauch- und Temperaturentwicklung eines definierten Feuers in einemdefinierten Raum und ein zweites Modul für die Auswahl und richtige Platzierung von Feuermeldern, wobei das zweite Modul die Eigenschaften der Melder mit der Entwicklung des definierten Feuers in dem definierten Raum verbindet. Vorzugsweise bilden die beiden Module Teil eines auf einem Datenträger gespeicherten Programms. Der Datenträger ist vorzugsweise durch eine CD-ROM oder eine Diskette gebildet.

Eine bevorzugte Ausführungsform des erfindungsgemässen Planungswerkzeugs ist dadurch gekennzeichnet, dass das Programm in zwei Teile "Berechnung und Simulation" und "Benutzeroberfläche" unterteilt ist, wobei die beiden genannten Module den Programmteil "Berechnung und Simulation" bilden. Vorzugsweise ist zwischen den Programmteilen "Berechnung und Simulation" und "Benutzeroberfläche" eine Schnittstelle vorgesehen, welche ein File mit allenParametern enthält.

Die Erfindung betrifft weiter ein Rechnersystem zur Durchführung des genannten Verfahrens. Eine bevorzugte Ausführungsform des erfindungsgemässen Rechnersystems ist gekennzeichnet durch einen Laptop oder einen anderen transportablen Rechner mit einer Eingabetastatur für die Eingabe der genannten Parameter, einem Bildschirm und einem Disketten- und/oder CD-ROM-Laufwerk zur Aufnahme des genannten Planungswerkzeugs.

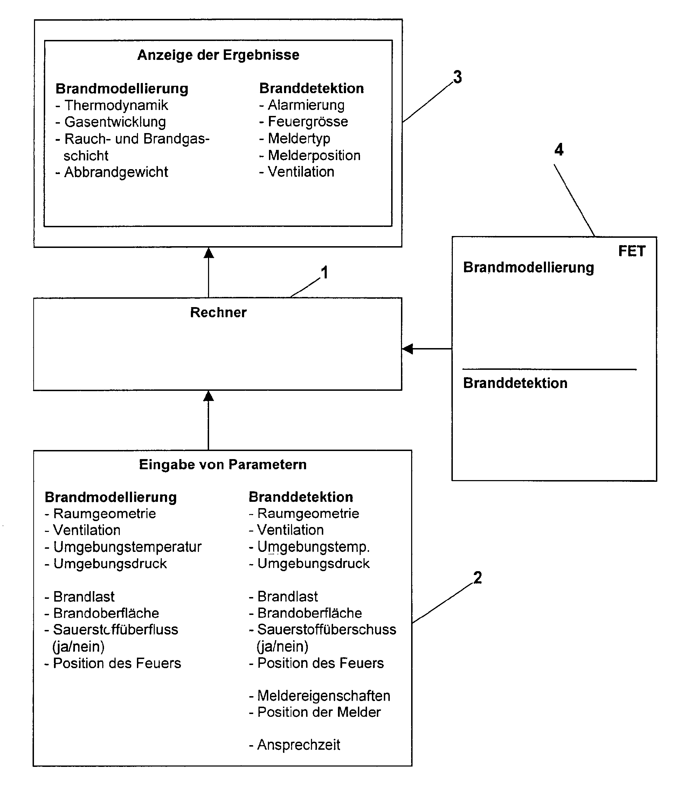

Im folgenden wird die Erfindung anhand eines Ausführungsbeispiels und der einzigenZeichnung näher beschrieben, wobei die Zeichnung ein Blockdiagramm des erfindungsgemässen Rechnersystems zeigt.

Das dargestellte Rechnersystem umfasst einen mit dem Bezugszeichen 1 bezeichnetenRechner, beispielsweise einen PC oder Laptop, mit einer Tastatur 2 zur Eingabe von Parametern und einem Bildschirm 3 zur Ausgabe von Ergebnissen. Der Rechner weist ein Laufwerk für einen Datenträger 4, beispielsweise eine CD-ROM oder Diskette, sowie einen Anschluss für einen Drucker auf. Der Datenträger 4 enthält ein Programm für die Unterstützung vonProjektierungsabläufen für Gefahren-, beispielsweise Brandmeldeanlagen. Das im folgenden als FET (= Fire Engineering Tool) bezeichnete Programm auf dem Datenträger 4 ist ein Werkzeug, das den Personen vor Ort, beispielsweise den Verkaufsingenieuren, als Hilfsmittel zur optimalen Auslegung einer Brandmeldeanlage zur Verfügung steht.

Das Programm unterstützt insbesondere die folgenden Arbeiten:
- Planung einer Brandmeldeanlage für ein schwieriges Umfeld (Auswahl, Konfiguration und Positionierung der Melder);
- Abschätzung des Ansprechverhaltens einer Brandmeldeanlage (Feuergrösse, Ansprechzeit); und optional
- Festlegung eines Abnahme-Testfeuers zur Überprüfung einer Brandmeldeanlage (Grösse und Art des Testfeuers). Bezüglich des Testfeuers wird auf die europäische Anmeldung Nr. 01 116 527.1 der Siemens Building Technologies AG verwiesen.

Das FET besteht aus zwei Modulen, einem Modul "Brandmodellierung" und einem Modul "Branddetektion". Mit dem Modul "Brandmodellierung" werden Aussagen zu einerBrandentwicklung unter gegebenen Bedingungen möglich und mit dem Modul "Branddetektion"Aussagen bezüglich des Ansprechverhaltens von Brandmeldern auf verschiedene Feuerarten und Feuergrössen. Das Modul "Brandmodellierung" stützt sich auf eine thermodynamischeModellierung der Brandvorgänge, wobei die thermodynamischen Modelle die Erhaltungsgrössen der Physik (Masse, Energie, Impuls) erfüllen und nur wenige empirische Werte benötigen. Diethermodynamische Modellierung der Brandvorgänge liefert die Temperatur in der Flammenzone und die Temperatur im Plume sowie die räumliche Ausbreitung der Brandgase. Das Modul ermöglicht also die Berechnung der Rauch- und Temperaturentwicklung eines definiertes Feuers in einem bestimmten Raum, sofern die erforderlichen Parameter eingegeben werden. Diese sind die Parameter Raum und Feuer.

Wenn auch die Festlegung eines Abnahme-Testfeuers unterstützt werden soll, dann enthält das FET ein drittes Modul "Rauchgenerator", mit welchem der in der EP-Anmeldung Nr. 0 116 527.1 beschriebene Rauchgenerator für Testfeuer simuliert wird.

Der Parameter Raum umfasst die folgenden Werte:
- Raumgeometrie: Breite, Tiefe, Höhe und Deckenkonstruktion des betrachteten Raums
- Ventilation: Luftwechsel pro Zeiteinheit
- Umgebungstemperatur zu Anfangstemperatur
- Umgebungsdruck

Für den Parameter Feuer werden folgende Werte benötigt:
- Brandlast: Art der Materialien, Zusammensetzung der Brandlast aus diesen
- Brandoberfläche (angenommene Oberfläche des Feuers)
- Sauerstoffüberschuss ja oder nein
- Position des Feuers (gemessen von einer Ecke aus).

Als Resultate liefert das Modell "Brandmodellierung" für die eingegebenen Parameter folgende Werte:
- Thermodynamik (Flammenzone, Plume)
- Gasentwicklung
- Rauchentwicklung
- Rauch- und Brandgasschicht
- Abbrandgewicht.

Diesen Resultaten kann man insbesondere entnehmen, wie sich ein Feuer in dem betrachteten Raum entwickelt, welchen Einfluss Ventilation und Brandlast auf das Feuer haben und mitwelcher Temperatur, Rauchkonzentration und Flammenhöhe zu rechnen ist.

Das Modul "Branddtektion" basiert auf dem Modul "Brandmodellierung" und ermöglicht dierichtige Wahl und Platzierung der Melder. Es enthält eine komplette Liste der verfügbaren Melder und von deren Parametersätzen und verbindet die Eigenschaften der Melder mit derEntwicklung eines definierten Feuers in einem vorgegebenen Raum. Es hilft bei der Planung einer Brandmeldeanlage und gibt Antworten bezüglich von deren Ansprechverhalten, zum Beispiel: Welcher Melder mit welcher Einstellung reagiert in einem Raum R auf ein Feuer F? Wie sieht das Ansprechverhalten eines Melders M bei ein- und ausgeschalteter Ventilation aus? Wie gross muss ein Feuer F sein, um beim Melder M mit der Einstellung E einen Alarm auszulösen?

Das Modul beantwortet Fragen aus der Sicht "Feuer" (z.B. Welche Feuergrösse löst bei einem gegebenen Melder und definierter Position einen Alarm aus?) als auch aus der Sicht "Melder" (z.B. Wo muss ein Melder positioniert werden, damit er ein Feuer derGrösse X noch detektiert?). So wie beim Modul "Brandmodellierung" sind auch bei diesem Modul die Parameter Raum und Feuer einzugeben und zusätzlich zu diesen die Parameter Melder und Ansprechzeit.

Der Parameter Melder umfasst die folgenden Werte:
- Meldereigenschaften (je nach Meldertyp eine oder mehrere der Eigenschaften: Rauchverhalten, Temperaturverhalten, Ansprechverhalten auf Flammen, Ansprechverhalten auf Brandgase; jeweils mit in der Regel mehr als einer Empfindlichkeitsstufe)
- Melderposition (Position des gewählten Melders (gemessen von der selben Ecke wie die Position des Feuers).

Der Parameter Ansprechzeit ist die Angabe der Zeit, innerhalb welcher der Melder das jeweilige Feuer detektieren soll.

Je nach Fragestellung sind unterschiedliche Eingaben erforderlich und das Modul errechnet unterschiedliche Resultate; die Resultate sind die folgenden:
- Alarmierung
   - Frage: Löst der gewählte Melder bei definiertem Feuer einen Alarm aus?
   - Eingaben: Alle Raum-, Melder- und Feuer-Parameter.
   - Resultat: Ansprechverhalten.
- Feuergrösse
   - Frage: Welche minimale Feuergrösse/Brandoberfläche ist notwendig, damit bei gewähltem Melder und definiertem Feuer innerhalb einer Zeit T ein Alarm ausgelöst wird?
   - Eingaben: Alle Raum-, und Melderparameter, Feuer-Parameter ohne Brandoberfläche, geforderte Ansprechzeit.
   - Resultat: Benötigte Brandoberfläche.
- Meldertyp
   - Frage: Welcher Melder löst bei definiertem Feuer innerhalb der Zeit T einen Alarm aus?
   - Eingaben: Alle Raum- und Feuer-Parameter, Position des Melders.
   - Resultat: Liste mit Typen und Parametersätzen der Melder, die innerhalb der Zeit T einen Alarm auslösen.
- Melderposition
   - Frage: Welcher maximale Abstand Melder zu Feuer/Flamme ist noch erlaubt, damit bei gewähltem Melder und definiertem Feuer innerhalb der Zeit T ein Alarm ausgelöst wird?
   - Eingaben: Alle Raum-, Melder- und Feuerparameter ohne Position von Melder und Feuer, Ansprechzeit.
   - Resultat: Maximaler Radius um den Melder.
- Ventilation
   - Frage: Welche maximale Ventilation [Luftwechsel pro Stunde] ist noch erlaubt, damit bei gewähltem Melder und definiertem Feuer innerhalb der Zeit T ein Alarm ausgelöst wird?
   - Eingaben: Raumgeometrie, alle Melder- und Feuer-Parameter, geforderte Ansprechzeit.
   - Resultat: Maximaler, noch erlaubter Luftwechsel).

Die Eingabe aller Parameter erfolgt manuell (Tastatur 2), wobei jedoch die letzte Eingabegespeichert wird, so dass immer nur diejenigen Parameter eingegeben werden müssen, die sich gegenüber der vorhergehenden Eingabe verändert haben. Eingaben können auch unter einem "Projektnamen" in einem File gespeichert und später beliebig abgerufen und unter Änderung der gegebenenfalls zu ändernden Werte für eine neue Eingabe verwendet werden.

Die FET Software ist in zwei Teile "Berechnung und Simulation" und "Benutzeroberfläche"aufgeteilt, wobei für die Übergabe der Parameter und der berechneten Werte eine genau definierte Schnittstelle vorgesehen ist. Diese Schnittstelle besteht aus einem File mit allen Parametern, einem Befehl, der das entsprechende Berechnungsmodul aufruft und aus einer AnzahlResultatfiles, in denen die Ergebnisse der Berechnungen gespeichert sind.

Im File Parameter sind immer alle Eingabeparameter (gebrauchte und nicht gebrauchte)gespeichert. Sobald ein Berechnungsmodul aufgerufen wird, liest es die benötigten Parameter aus diesem File.

## Patentansprüche

1. Verfahren zur Durchführung von Projektierungsabläufen für Gefahrenmeldeanlagen mit Hilfe eines Rechners (1), **gekennzeichnet durch** ein auf dem Rechner implementierbaresPlanungswerkzeug für die Berechnung von Brandentwicklungen und des Ansprechverhaltens von Brandmeldeanlagen anhand eines Brandmodells und von Parametern.

2. Verfahren nach Anspruch 1, **dadurch gekennzeichnet, dass** das Planungswerkzeug ein erstes Modul für die Berechnung der Rauch- und Temperaturentwicklung eines definierten Feuers in einem definierten Raum und ein zweites Modul für die Auswahl und richtigePlatzierung von Feuermeldern umfasst, wobei das zweite Modul die Eigenschaften der Melder mit der Entwicklung des definierten Feuers in dem definierten Raum verbindet.

3. Verfahren nach Anspruch 2, **dadurch gekennzeichnet, dass** die Parameter in den Rechner (1) eingegeben werden.

4. Verfahren nach Anspruch 3, **dadurch gekennzeichnet, dass** für die Berechnungen desersen Moduls die Parameter Raum und Feuer und für die Berechnungen des zweiten Moduls die Parameter Raum, Feuer, Melder und Ansprechzeit eingegeben werden.

5. Verfahren nach Anspruch 4, **dadurch gekennzeichnet, dass** der Parameter Raum Angaben über einen oder mehrere der Werte Raumgeometrie, Ventilation, Umgebungstemperatur und Umgebungsdruck und der Parameter Feuer Angaben über die Eigenschaften und/oder die Position des Feuers enthält.

6. Verfahren nach Anspruch 5, **dadurch gekennzeichnet, dass** die Angaben über dieEigenschaften des Feuers Werte betreffend die Brandlast und/oder die Brandoberfläche und/oder einen eventuellen Sauerstoffüberschuss enthalten.

7. Verfahren nach einem der Ansprüche 4 bis 6, **dadurch gekennzeichnet, dass** der Parameter Melder Angaben über Eigenschaften und/oder Position der in Frage kommenden Brandmelder enthält.

8. Verfahren nach einem der Ansprüche 3 bis 7, **dadurch gekennzeichnet**, **dadurch gekennzeichnet, dass** vom ersten Modul einer oder mehrere der Werte Thermodynamik (Energieund Massenbilanz in der Reaktionszone und im Plume), Gasentwicklung, Rauchentwicklung, Rauch- und Brandgasschicht und Abbrandgewicht berechnet und ausgegeben werden.

9. Verfahren nach einem der Ansprüche 3 bis 8, **dadurch gekennzeichnet, dass** vom zweiten Modul je nach Eingabe-Parametern Angaben betreffend Alarmauslösung in Abhängigkeit von Meldertyp und Melderposition oder betreffend Meldertyp und Melderposition inAbhängigkeit vom Feuer ausgegeben werden.

10. Planungswerkzeug zur Unterstützung von Projektierungsabläufen fürGefahrenmeldeanlagen, **gekennzeichnet durch** ein erstes Modul für die Berechnung der Rauch undTemperaturentwicklung eines definierten Feuers in einem definierten Raum und ein zweites Modul für die Auswahl und richtige Platzierung von Feuermeldern, wobei das zweite Modul die Eigenschaften der Melder mit der Entwicklung des definierten Feuers in dem definierten Raum verbindet.

11. Planungswerkzeug nach Anspruch 10, **dadurch gekennzeichnet, dass** die beiden Module Teil eines auf einem Datenträger (4) gespeicherten Programms bilden.

12. Planungswerkzeug nach Anspruch 11, **dadurch gekennzeichnet, dass** das Programm in zwei Teile "Berechnung und Simulation" und "Benutzeroberfläche" unterteilt ist, wobei die beiden genannten Module den Programmteil "Berechnung und Simulation" bilden.

13. Planungswerkzeug nach Anspruch 12, **dadurch gekennzeichnet, dass** zwischen den Programmteilen "Berechnung und Simulation" und "Benutzeroberfläche" eine Schnittstelle vorgesehen ist, welche ein File mit allen Parametern enthält.

14. Planungswerkzeug nach einem der Ansprüche 11 bis 13, **dadurch gekennzeichnet, dass** der Datenträger (4) durch eine CD-ROM oder eine Diskette gebildet ist.

15. Rechnersytem zur Durchführung des Verfahrens nach einem der Ansprüche 1 bis 9.

16. Rechnersystem nach Anspruch 15, **gekennzeichnet durch** einen Laptop oder einen anderen transportablen Rechner (1) mit einer Eingabetastatur (2) für die Eingabe der genanntenParameter, einem Bildschirm (3) und einem Disketten- und/oder CD-ROM-Laufwerk zurAufnahme des genannten Planungswerkzeugs.
